# FASCICULE DE BREVET EUROPEEN

(11) **EP 2 237 698 B1**
(45) Date de publication et mention de la délivrance du brevet: **22.04.2015**
(21) Numéro de dépôt: 09704859.9
(22) Date de dépôt: 23.01.2009
(51) Int. Cl.: A44C 17/00, A44C 27/00, H01L 21/316

(54) **OBJET MUNI D'UN ELEMENT GRAPHIQUE REPORTE SUR UN SUPPORT ET PROCEDE DE REALISATION D'UN TEL OBJET**
MIT EINEM GRAPHISCHEN ELEMENT AUF EINEM TRÄGER VERSEHENES OBJEKT UND VERFAHREN ZUR HERSTELLUNG DES OBJEKTS
OBJECT PROVIDED WITH A GRAPHICS ELEMENT TRANSFERRED ONTO A SUPPORT WAFER AND METHOD OF PRODUCING SUCH AN OBJECT

(30) Priorité: 25.01.2008 FR 0850475
(43) Date de publication de la demande: 13.10.2010
(73) Titulaire: Commissariat à l'Énergie Atomique et aux Énergies Alternatives, 75015 Paris (FR)
(72) Inventeur: REY, Alain-Marcel, F-26540 Mours St Eusebe (FR); CLERC, Jean-Frédéric, F-38320 Brie Et Angonnes (FR); SOUBIE, Alain, F-38120 Saint Egreve (FR); VANDROUX, Laurent, F-38570 Le Cheylas (FR)
(74) Mandataire: Ilgart, Jean-Christophe
(86) Numéro de dépôt international: PCT/EP2009/050779
(87) Numéro de publication internationale: WO 2009/092794

(56) Documents cités:
- EP-A- 0 450 558
- EP-A- 0 627 763
- EP-A- 1 544 178
- WO-A-99/55188
- FR-A- 2 851 496
- FR-A- 2 888 402
- US-A- 5 552 628
- US-A- 5 972 233

## Description

### DOMAINE TECHNIQUE

L'invention concerne un objet, tel qu'un objet massif, par exemple de type bijou, pierre, montre (par exemple un verre de montre, un cadran ou un fond de boîtier), équipement électronique nomade (par exemple une fenêtre ou un écran) ou tout autre support solide, comportant un élément graphique, ou graphisme, tel qu'une décoration, des caractères typographiques, un dessin ou encore une photo, par exemple de dimensions micrométriques et/ou nanométriques. L'invention concerne également un procédé de réalisation d'un tel objet.

L'invention trouve des applications dans divers domaines industriels, culturels ou artistiques. Pour l'industrie horlogère, des verres de montre ou des fonds de boîtiers peuvent être fabriqués selon cette invention afin de réaliser des graphismes ou décorations semi-transparentes de très haute qualité visuelle et très robustes.

L'invention peut s'appliquer également dans le domaine de la joaillerie, notamment pour la réalisation de pierres comportant des décorations ou textes aux dimensions micrométriques et/ou nanométriques, par exemple utilisées pour faire des pendentifs, des bagues, ou des boucles d'oreille.

L'invention peut également être utilisée pour réaliser le stockage d'une grande quantité d'informations dans des petits volumes (par exemple quelques cm² de surface pour moins de 2 mm d'épaisseur) avec une très bonne durabilité (plusieurs milliers ou millions d'années).

### ART ANTERIEUR

Il est connu de réaliser des objets comportant des décorations ou graphismes de taille micrométriques obtenus par la mise en oeuvre de techniques issues des microtechnologies, par exemple par photolithographie sur un objet. Toutefois, la durabilité et la robustesse mécanique de ces décorations réalisées en surface des objets sont généralement médiocres.

Un procédé de protection d'un graphisme réalisé sur un objet est décrit dans le document FR 2 851 496. Dans ce document, le graphisme est tout d'abord réalisé par photolithographie sur un substrat transparent. Le substrat est ensuite retourné puis solidarisé sur l'objet souhaité par collage ou sertissage.

Un tel procédé présente plusieurs inconvénients. En effet, les colles utilisées pour solidariser le substrat à l'objet comportent des matériaux organiques présentant une durée de vie limitée. Les objets ainsi réalisés présentent donc une durée de vie limitée. D'autre part, les propriétés optiques de ses colles se dégradent au fil du temps, ce qui altère la lisibilité des graphismes réalisés sur le substrat. Le sertissage permet un assemblage mécanique solide du substrat à l'objet, mais n'assure pas une bonne intégrité de l'objet et de son graphisme car le sertissage réalisé peut être démonté sans détruire l'objet, ce qui pose un problème si l'on souhaite réaliser un objet comportant un graphisme inviolable.

EP-A-1544178 décrit un objet muni d'un élément graphique, comportant un substrat transparent, dont une face comprend des creux formant un motif de l'élément graphique remplis par au moins un matériau, ladite face du substrat étant solidarisée à une face d'au moins un support.

### EXPOSÉ DE L'INVENTION

Un but de la présente invention est de proposer un objet comportant un ou plusieurs éléments graphiques, ainsi qu'un procédé de réalisation d'un tel objet, ne présentant pas les inconvénients de l'art antérieur décrits précédemment.

Pour cela, la présente invention propose un objet muni d'au moins un élément graphique, comportant au moins un substrat au moins partiellement transparent dont au moins une face comprend des creux formant un motif de l'élément graphique remplis par au moins un matériau, ladite face du substrat étant solidarisée à au moins une face d'au moins un support par adhésion moléculaire, le substrat et le support formant une structure monolithique.

Ainsi, l'élément graphique, qui peut être de dimensions micrométriques et/ou nanométriques, formé par le matériau disposé dans les creux, est réalisé sur l'objet de manière robuste, durable et intègre (désolidarisation impossible sans dégrader l'objet) grâce au collage par adhésion moléculaire réalisé entre le substrat et le support de l'objet.

Le ou les graphismes, ou textes, formés par l'élément graphique, sont donc enfermés hermétiquement entre deux composants solides massifs, d'un côté le substrat et de l'autre le support, grâce au collage par adhésion moléculaire réalisé. Ce scellement hermétique forme notamment une barrière à la diffusion de l'humidité ou de tout produit chimique gazeux ou liquide (sauf des produits éventuellement susceptibles de détruire le substrat ou le support).

Le collage par adhésion moléculaire permet de former une structure monolithique, à partir du substrat et du support de l'objet, dans lequel est enfermé l'élément graphique. Lorsque le substrat et le support sont de même nature, on recompose alors un cristal massif, par exemple sans interface entre le support et le substrat, avec un élément graphique noyé dans le cristal. Les forces d'adhésion entre le substrat et le support sont supérieures aux forces de cohésion des matériaux. Ainsi, toute tentative de décollement du substrat conduirait à une destruction de l'objet.

L'élément graphique est protégé mécaniquement par toute l'épaisseur du substrat d'un côté et par toute l'épaisseur du support de l'autre. Le substrat et/ou le support doivent être abrasés ou usés intégralement avant de pouvoir détruire l'élément graphique. Cette protection peut donc être maximisée en choisissant des matériaux très durs, par exemple du saphir pour le substrat qui ne peut être rayé que par du carbure de silicium ou du diamant.

En choisissant par exemple un substrat et/ou un support à base de saphir, dont la température de fusion est égale à environ 1790°C, et un matériau, disposé dans les creux et formant l'élément graphique, à base de platine, dont la température de fusion est égale à environ 1768°C, on obtient un objet présentant une forte résistance aux agressions thermiques (par exemple à un incendie), et donc une excellente durabilité.

Un collage par adhésion moléculaire réalisé entre deux matériaux de même nature permet d'éviter tout risque de vieillissement potentiel de l'assemblage par fatigue mécanique induite par les dilatations thermiques différentielles d'autres matériaux supplémentaires.

De plus, le collage par adhésion moléculaire permet l'utilisation de matériaux minéraux dont les propriétés optiques sont stables dans le temps. La structure réalisée ne subit donc pas de dégradation de ses qualités optiques (notamment la visibilité de l'élément graphique) due au temps.

Lorsque le support est une pierre précieuse ou semi-précieuse et que le substrat est à base du même matériau que le support, on peut ainsi reconstituer une pierre massive, notamment lorsque aucun autre matériau n'est utilisé pour le collage par adhésion moléculaire, comportant l'élément graphique réalisé à l'intérieur, c'est-à-dire « noyé » dans la pierre.

De plus, cet objet peut être réalisé indépendamment de la densité des motifs de l'élément graphique.

Lorsque l'élément graphique est réalisé à partir d'un matériau métallique disposé dans les creux, les graphismes ou textes peuvent donc être réalisés avec un matériau précieux et très stable, c'est-à-dire non sensible à la corrosion ou aux dégradations dans le temps.

De plus, des motifs de dimensions micrométriques réalisés sur des objets tels que des pierres précieuses peuvent être totalement invisibles à l'oeil nu. On peut ainsi avoir une traçabilité totalement discrète de l'objet, permettant par exemple de lutter contre la contrefaçon et le vol de l'objet.

Le matériau disposé dans les creux peut être à base d'au moins un matériau minéral, par exemple un métal, et/ou le substrat peut être à base d'au moins un matériau amorphe ou cristallin.

L'objet peut comporter en outre un matériau d'adhérence disposé dans les creux, entre le matériau également disposé dans les creux et le substrat.

Le matériau d'adhérence peut être à base d'au moins un métal et/ou d'un nitrure métallique et/ou d'un oxyde métallique.

L'objet peut comporter en outre au moins une première couche d'adhésion et/ou au moins une seconde couche d'adhésion disposées entre la face du substrat comportant les creux et le support, l'adhésion moléculaire pouvant être formée entre la première couche d'adhésion et le support, ou entre la seconde couche d'adhésion et la face du substrat comportant les creux, ou entre la première couche d'adhésion et la seconde couche d'adhésion.

Grâce à la première et/ou la seconde couche d'adhésion qui peuvent être réalisées respectivement sur le substrat et/ou sur le support avant le collage par adhésion moléculaire, le substrat et/ou le support peuvent être de n'importe quelle nature ou à base de n'importe quel matériau, par exemple du type minéral solide.

La première couche d'adhésion et/ou la seconde couche d'adhésion peuvent être à base d'au moins un matériau minéral.

Lorsque le matériau disposé dans les creux est à base de métal, ledit matériau peut comporter une zone à base dudit métal et d'un semi-conducteur au niveau d'une face du matériau opposée à une autre face du matériau se trouvant du côté des creux. Par exemple, ladite zone peut être à base de siliciure. Ainsi, on améliore l'adhérence de la couche d'adhésion avec le matériau disposé dans les creux.

Le substrat peut comporter une couche mince au moins partiellement transparente dont une face peut être ladite face du substrat comportant les creux et solidarisée par adhésion moléculaire au support.

On entend par couche mince, ici et dans tout le reste du document une couche dont l'épaisseur est inférieure à environ 10 µm.

On peut ainsi obtenir une couche mince sur laquelle est réalisé un élément graphique et reportée sur un support, par exemple une pierre précieuse plus épaisse, c'est-à-dire dont l'épaisseur est par exemple égale à au moins 1 millimètre ou supérieure à environ 100 µm. La couche mince représente donc dans ce cas, par rapport à l'épaisseur totale de l'objet, une épaisseur minime, par exemple un millième, ou moins, de l'épaisseur totale de l'objet.

L'objet peut être un bijou, une pierre, une montre, un dispositif électronique ou un support de données.

L'invention concerne également un procédé de réalisation d'un objet muni d'au moins un élément graphique, comportant au moins les étapes de :
a) gravure d'au moins une face d'un substrat au moins partiellement transparent selon un motif de l'élément graphique, formant des creux dans ladite face,
b) dépôt d'au moins un matériau au moins dans les creux formés dans la face du substrat,
c) solidarisation de la face du substrat comportant les creux à au moins une face d'au moins un support par adhésion moléculaire, le substrat et le support formant une structure monolithique.

L'étape b) de dépôt peut être obtenue par la mise en oeuvre d'une étape de dépôt d'une couche à base du matériau sur la face du substrat comportant les creux et dans les creux, et d'une étape de polissage mécano-chimique de ladite couche à base du matériau avec arrêt sur la face du substrat, ne laissant subsister de ladite couche que des portions de matériau disposées dans les creux.

Dans une variante, l'étape b) de dépôt peut être obtenue par la mise en oeuvre d'une étape de remplissage des creux par sérigraphie, le matériau disposé dans les creux pouvant comporter une encre ou pâte chargée en métal, et d'une étape de séchage du matériau. Dans ce cas, le procédé peut comporter en outre, après l'étape de séchage du matériau disposé dans les creux, une étape de polissage mécano-chimique de la face du substrat, permettant de nettoyer et traiter cette face du substrat.

Le procédé peut comporter en outre, entre l'étape a) de gravure et l'étape b) de dépôt du matériau dans les creux, une étape de dépôt d'un matériau d'adhérence dans les creux tel que le matériau d'adhérence remplisse partiellement les creux, l'autre matériau pouvant être ensuite déposé, au cours de l'étape b), sur le matériau d'adhérence.

L'étape de dépôt du matériau d'adhérence peut être obtenue par la mise en oeuvre d'une étape de dépôt d'une couche à base du matériau d'adhérence sur la face du substrat comportant les creux et dans les creux, l'étape b) de dépôt pouvant être obtenue par la mise en oeuvre d'une étape de dépôt d'une couche à base de l'autre matériau sur la couche à base du matériau d'adhérence et d'une étape de polissage mécano-chimique desdites couches à base du matériau d'adhérence et de l'autre matériau avec arrêt sur la face du substrat, ne laissant subsister desdites couches que des portions de matériaux disposées dans les creux.

Le procédé peut comporter en outre, entre l'étape b) de dépôt et l'étape c) de solidarisation, une étape de dépôt d'une couche d'adhésion sur la face du substrat comportant les creux, pouvant recouvrir également le ou les matériaux disposés dans les creux, l'étape c) de solidarisation pouvant être obtenue par la mise en oeuvre d'un collage par adhésion moléculaire entre ladite couche d'adhésion et le support.

Dans ce cas, le procédé peut comporter en outre, entre l'étape de dépôt de la couche d'adhésion sur la face du substrat comportant les creux et l'étape c) de solidarisation, une étape de polissage mécano-chimique de la couche d'adhésion déposée sur la face du substrat comportant les creux.

Dans une variante, le procédé peut comporter en outre, avant l'étape c) de solidarisation, une étape de dépôt d'une couche d'adhésion sur la face du support, l'étape c) de solidarisation pouvant être obtenue par la mise en oeuvre d'un collage par adhésion moléculaire entre ladite couche d'adhésion et la face du substrat comportant les creux.

Dans une autre variante, le procédé peut comporter en outre :
- entre l'étape b) de dépôt et l'étape c) de solidarisation, une étape de dépôt d'une première couche d'adhésion sur la face du substrat comportant les creux, pouvant recouvrir également le ou les matériaux disposés dans les creux,
- avant l'étape c) de solidarisation, une étape de dépôt d'une seconde couche d'adhésion sur la face du support,
l'étape c) de solidarisation pouvant être obtenue par la mise en oeuvre d'un collage par adhésion moléculaire entre les deux couches d'adhésion.

Le procédé peut comporter en outre, lorsque le matériau déposé à l'étape b) est à base de métal, entre l'étape b) de dépôt et l'étape de dépôt de la couche d'adhésion, une étape de formation d'une zone à base dudit métal et d'un semi-conducteur au niveau d'une face du matériau opposée à une autre face du matériau se trouvant du côté des creux.

Dans ce cas, l'étape de formation de ladite zone peut être obtenue par la mise en oeuvre d'une étape de siliciuration du matériau déposé dans les creux.

Le procédé peut comporter en outre, entre l'étape de dépôt de la couche d'adhésion sur la face du support et l'étape c) de solidarisation, une étape de polissage mécano-chimique de la couche d'adhésion déposée sur le support.

L'étape a) de gravure de la face du substrat peut être obtenue par la mise en oeuvre d'étapes de masquage, de lithographie et de gravure dans la face du substrat, ou d'au moins une étape d'ablation laser directement dans la face du substrat.

Le procédé peut comporter en outre, avant l'étape a) de gravure, une étape de réalisation d'une couche mince au moins partiellement transparente sur un substrat massif, pouvant former le substrat au moins partiellement transparent, et une étape de réalisation d'une interface de fracture entre la couche mince et le substrat massif, les creux formés à l'étape a) de gravure pouvant être réalisés dans une face de la couche mince, et pouvant comporter en outre, après l'étape c) de solidarisation, une étape de fracture entre la couche mince et le substrat massif, au niveau de l'interface de fracture, la structure monolithique pouvant être formée par la couche mince et le support.

Ainsi, il est possible de manipuler des films minces ou très minces, par exemple d'épaisseur inférieure à environ 10 µm ou inférieure à environ 1 µm, comportant des motifs d'éléments graphiques et de les coller sur un support massif, par exemple une pierre précieuse ou semi-précieuse. On réalise ainsi des graphismes sans modification physique ou géométrique de l'objet.

La couche mince peut être réalisée par un dépôt CVD (dépôt chimique en phase vapeur), par exemple PECVD (dépôt chimique en phase vapeur assisté par plasma), MOCVD (dépôt chimique en phase vapeur organométallique) ou ALCVD (dépôt chimique de couches atomiques en phase vapeur), ou PVD (dépôt physique en phase vapeur, c'est-à-dire évaporation ou pulvérisation cathodique) sur le substrat massif, et/ou l'interface de fracture pouvant être réalisée par implantation ionique.

Dans une variante, le procédé peut comporter en outre, avant l'étape a) de gravure, une étape de réalisation d'une interface de fracture dans le substrat, une première partie du substrat pouvant former une couche mince au moins partiellement transparente et une seconde partie du substrat pouvant former un substrat massif, l'interface de fracture pouvant être disposée entre les deux parties du substrat, les creux formés à l'étape a) de gravure pouvant être réalisés dans une face de la couche mince, et pouvant comporter en outre, après l'étape c) de solidarisation, une étape de fracture entre la couche mince et le substrat massif, au niveau de l'interface de fracture, la structure monolithique pouvant être formée par la couche mince et le support.

Le procédé peut comporter en outre, après l'étape c) de solidarisation, une étape de traitement thermique de l'objet pouvant consolider l'adhésion moléculaire.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- les figures 1A à 1I représentent les étapes d'un procédé de réalisation d'un objet muni d'un élément graphique, selon un premier mode de réalisation de la présente invention,
- les figures 2A à 2I représentent les étapes d'un procédé de réalisation d'un objet muni d'un élément graphique, selon un second mode de réalisation de la présente invention.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes) doivent être comprises comme n'étant pas exclusives les unes des autres et peuvent se combiner entre elles.

### EXPOSÉ DÉTAILLÉ DE MODES DE RÉALISATION de L'INVENTION

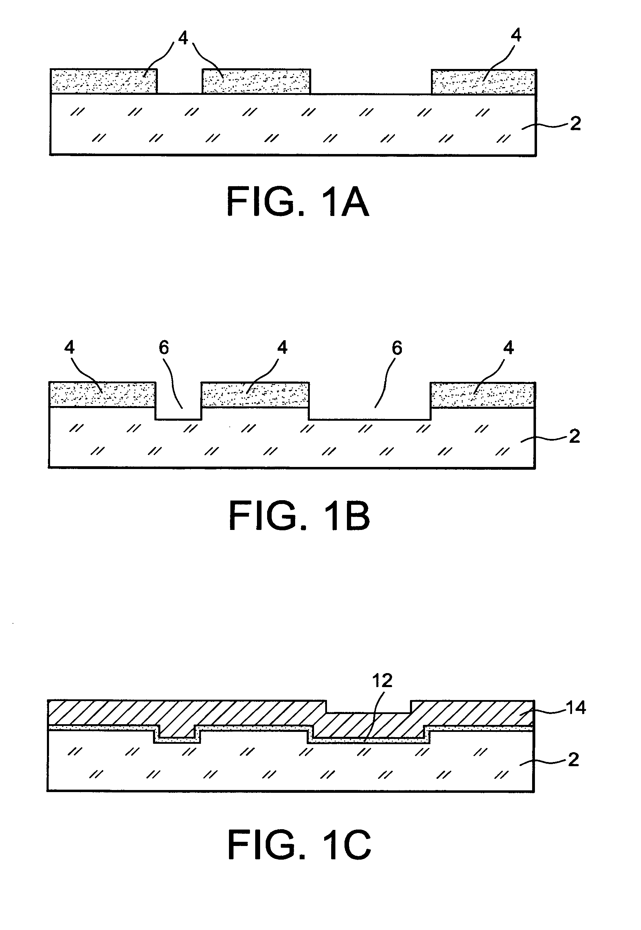

Un procédé de réalisation d'un objet 100 comportant un élément graphique reporté sur un support 20, par exemple un objet massif tel qu'un bijou, une montre, un équipement électronique, ou encore un support de conservation d'informations, va être décrit en liaison avec les figures 1A à 1I. Dans ce premier mode de réalisation, l'objet 100 est un support de conservation d'informations, ou support de données, dont l'élément graphique sont les données que l'on souhaite conserver.

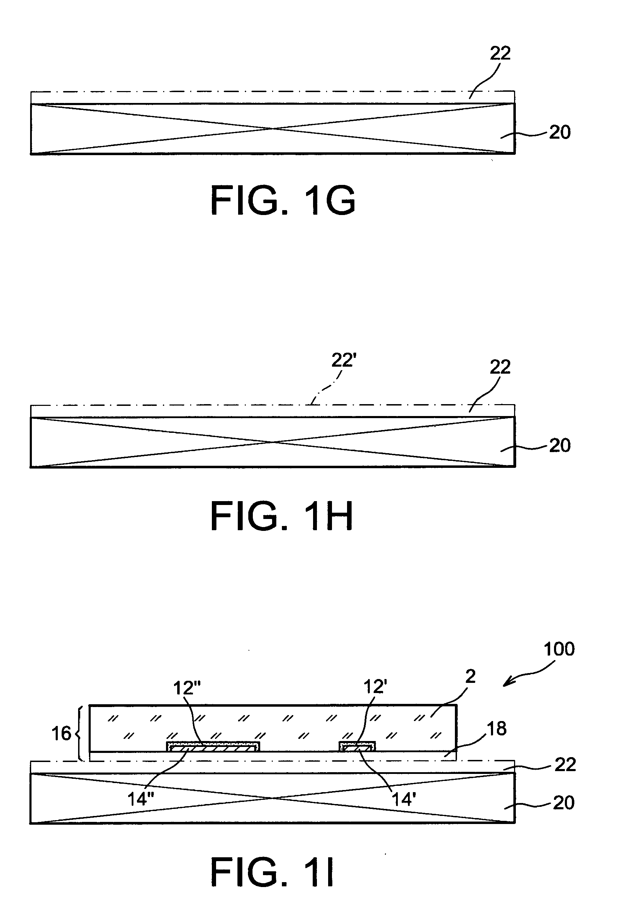

Comme représenté sur la figure 1A, on réalise tout d'abord sur une face d'un substrat 2, par exemple transparent ou au moins partiellement transparent, et à base d'un matériau amorphe, tel que du verre, ou cristallin, tel que du saphir ou du diamant, un masque 4, dont le motif correspond à celui de l'élément graphique à réaliser. Pour cela, une couche de résine photosensible est par exemple déposée sur le substrat 2. Une ou plusieurs étapes de lithographie et de gravure sont ensuite mises en oeuvre pour former le masque 4. Dans l'exemple de réalisation décrit ici, le masque 4 est donc formé par des portions restantes de la couche de résine photosensible déposée sur le substrat 2. La couche de résine photosensible est donc directement utilisée pour former le masque de gravure 4. Dans l'exemple décrit ici, la résine photosensible est négative, le motif de l'élément graphique étant formé par les portions du masque 4. Toutefois, il est également possible d'utiliser une résine photosensible positive. L'épaisseur du substrat 2 est par exemple égale à quelques centaines de micromètres, ou comprise entre environ 100 µm et 1 mm. L'épaisseur du support 20 (représenté sur les figures 1G à 1I) peut notamment être supérieure ou égale à l'épaisseur du substrat 2.

Comme représenté sur la figure 1B, la face du substrat 2 sur laquelle est réalisé le masque 4 est ensuite gravée par voie chimique isotrope ou anisotrope ou sèche (mode plasma, gravure ionique réactive ou usinage ionique) formant des creux 6 dont le motif est conforme à celui de l'élément graphique. Le masque de gravure 4 est ensuite éliminé. Le motif de l'élément graphique se trouve donc reporté dans le substrat 2.

Dans une variante de réalisation, il est possible que le masque 4 soit formé dans une couche, par exemple de type minéral (par exemple à base de dioxyde de silicium) ou à base de métal, déposée tout d'abord sur le substrat 2, et sur laquelle est ensuite déposée la couche à base de résine photosensible. Le motif de l'élément graphique est alors formé par lithographie et gravure dans la couche de résine. Ce motif est ensuite transféré dans la couche minérale ou métallique par gravure. Enfin, les portions restantes de la couche de résine sont ensuite éliminées par gravure. Le masque 4 est dans ce cas formé par les portions restantes de la couche minérale ou métallique. Cette variante peut notamment être utilisée pour réaliser un masque de gravure résistant à certains agents de gravure, utilisés pour graver le substrat 2, pouvant endommager un masque à base de résine (par exemple de l'eau régale). Le choix de l'une ou l'autre variante de réalisation du masque peut être réalisé en fonction du matériau à graver (matériau du substrat 2).

Dans une autre variante du procédé, il est possible de ne pas utiliser de masque de gravure. Dans ce cas, le motif de l'élément graphique est transféré directement dans le substrat 2, par exemple par ablation laser, par un laser femtoseconde.

On réalise ensuite un dépôt sur la face précédemment gravée du substrat 2, d'une couche d'adhérence 12, ainsi que dans les creux 6 précédemment réalisés. Une couche 14 est ensuite déposée sur la couche d'adhérence 12 (voir figure 1C). Les couches 12 et 14 sont par exemple obtenues par des dépôts de type PVD. Dans ce premier mode de réalisation, la couche 14 est à base de métal, par exemple de l'or, du platine, du tungstène, du titane, de l'oxyde métallique, etc. De manière générale, la couche 14 peut également être à base d'au moins un matériau minéral. Ce matériau peut notamment être opaque à la lumière. L'épaisseur de cette couche 14 est par exemple comprise entre environ 50 nm et 100 nm. L'épaisseur de la couche 14 peut notamment être choisie en fonction de la nature du matériau formant la couche 14, l'épaisseur choisie étant suffisante pour obtenir une certaine opacité de la couche 14. De plus, la somme des épaisseurs des couches 12 et 14 est ici supérieure à la profondeur des creux 6 réalisés dans le substrat 2.

Ainsi, étant donné que l'élément graphique que l'on souhaite réaliser est formé par les portions des couches 12 et 14 disposées dans les creux 6, l'élément graphique sera visible à travers le substrat 2 sur l'objet 100, l'opacité du matériau de la couche 14 permettant de faire ressortir visuellement l'élément graphique réalisé. La couche d'adhérence 12 est par exemple à base de titane, de nitrure de titane, d'oxyde de titane ou tout autre matériau permettant d'obtenir une bonne adhérence entre la couche 14 et le substrat 2. La nature de la couche d'adhérence 12 peut notamment être choisie en fonction de la nature du substrat 2 et de la couche 14. L'épaisseur de cette couche d'adhérence 12 peut par exemple être comprise entre environ 1 nm et 10 nm.

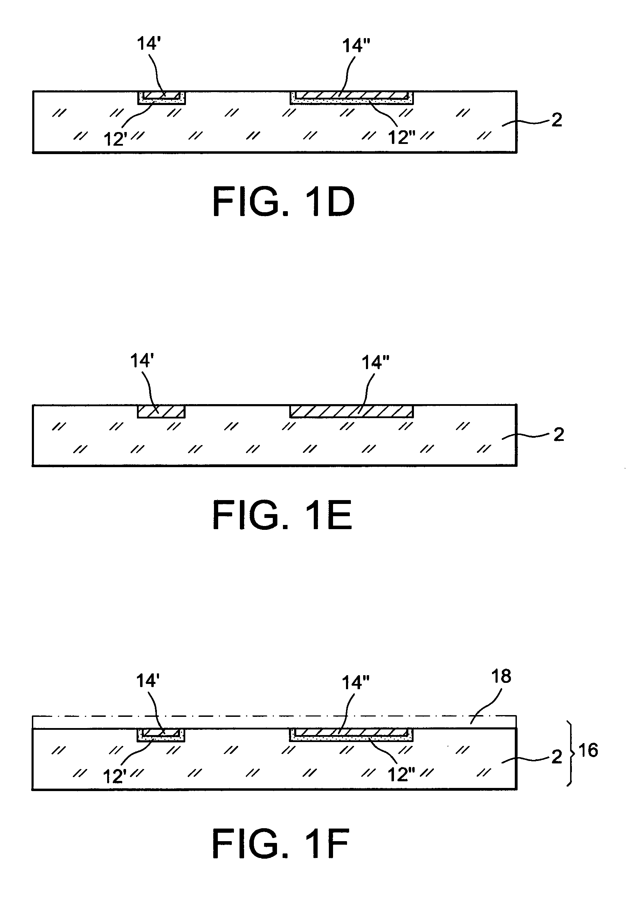

Comme représenté sur la figure 1D, on réalise ensuite un polissage mécano-chimique de la couche 14 et de la couche d'adhérence 12, avec arrêt sur la face du substrat 2 sur laquelle ont été déposées les couches 12 et 14. On conserve ainsi des portions 12', 12" de la couche d'adhérence 12 et des portions 14', 14" de la couche 14 disposées dans les creux précédemment réalisés dans le substrat 2. Ces portions restantes 12', 12" et 14', 14" forment donc le motif de l'élément graphique que l'on souhaite réaliser.

Dans une variante, la couche 14 peut être déposée sur le substrat 2 et dans les creux 6 formés dans le substrat 2 sans déposer au préalable de couche d'adhérence 12 sur le substrat 2. L'épaisseur de la couche 14 déposée peut dans ce cas être supérieure à la profondeur des creux 6. Comme décrit précédemment, on réalise alors un polissage mécano-chimique de la couche 14 déposée afin de ne conserver que les portions 14', 14" déposées dans les creux 6 (figure 1E). Dans cette variante, la couche 14 peut être à base d'une encre, ou pâte, chargée en métal et déposée directement dans les creux 6 du substrat 2 par sérigraphie. L'encre ou la pâte déposée est ensuite séchée avant de réaliser le polissage mécano-chimique.

Il est également possible de réaliser, par exemple par photolithographie et gravure, au moins une cavité dans le substrat 2 et/ou les portions 14', 14", au niveau de la face du substrat 2 comportant les creux 6. Un ou plusieurs micro-objets peuvent alors être disposés dans cette ou ces cavités.

Sur la figure 1F, une couche d'adhésion 18 est ensuite déposée, par exemple par CVD ou PVD, sur la face du substrat 2 comportant les portions 12', 12", 14', 14" déposées dans les creux. Cette couche d'adhésion 18 est par exemple à base d'un matériau minéral, tel que du dioxyde de silicium ou du nitrure de silicium. Le matériau de cette couche d'adhésion 18 est notamment choisi pour pouvoir réaliser par la suite un collage par adhésion moléculaire avec le support 20. Cette couche d'adhésion 18 est également destinée à assurer une protection du motif formé par les portions restantes 14', 14" de la couche 14.

Lorsque les portions restantes 14', 14" de la couche 14 sont à base de métal, il est possible de former dans ces portions restantes 14', 14", préalablement au dépôt de la couche d'adhésion 18, une zone à base du métal de la couche 14 et à base d'un semi-conducteur. Cette zone peut par exemple être formée par une siliciuration des portions restantes 14', 14". Cette siliciuration est par exemple obtenue par une décomposition de silane (SiH₄, ou plus généralement tout gaz de type SiₙH₂ₙ₊₂) sous atmosphère contrôlée, à une température par exemple comprise entre environ 200°C et 450°C et de préférence égale à environ 300°C. Le gaz ainsi décomposé réagit avec le métal des portions 14', 14" pour former la zone à base de métal et de semi-conducteur en surface des portions 14', 14". Par exemple, lorsque les portions 14', 14" sont à base de Pt, la zone obtenue après la siliciuration est alors à base de PtSi. Il est également possible que cette zone formée en surface des portions 14', 14" soit à base d'un semi-conducteur autre que du silicium.

En réalisant une telle siliciuration, ou plus généralement grâce à la présence de la zone à base de métal et de semi-conducteur en surface des portions restantes 14' et 14", on améliore l'adhérence de la couche d'adhésion 18 sur ces portions 14' et 14". De préférence, cette siliciuration peut être mise en oeuvre in situ, c'est-à-dire réalisée dans l'équipement utilisé pour réaliser le dépôt de la couche d'adhésion 18, sans mettre en oeuvre d'autres étapes entre l'étape de réalisation de la zone de métal et de semi-conducteur et le dépôt de la couche d'adhésion 18, ce qui permet de ne pas exposer la zone siliciurée à l'environnement extérieur et de conserver ainsi de meilleures propriétés d'adhérence de celle-ci vis-à-vis de la couche d'adhésion 18.

Dans une variante, il est également possible de réaliser tout d'abord un dépôt d'une couche anti-réflective et/ou d'autres couches sur la face du substrat 2 comportant les portions restantes 14', 14", puis de déposer la couche d'adhésion 18 sur cette couche anti-réflective et/ou sur les autres couches.

La couche d'adhésion 18 peut par exemple avoir une épaisseur comprise entre environ 100 nm et 1 µm.

Il est possible de réaliser ensuite un traitement de surface de la couche d'adhésion 18, par exemple un polissage mécano-chimique permettant d'éliminer l'éventuelle rugosité du substrat 2 pouvant se retrouver au niveau de la face supérieure de la couche d'adhésion 18. Ce polissage permet ainsi d'obtenir une surface plane.

On obtient ainsi un ensemble 16, formé ici par le substrat 2, les portions restantes 14', 14" de la couche 14, les portions restantes 12', 12" de la couche d'adhérence 12 et la couche d'adhésion 18, comportant le motif de l'élément graphique que l'on souhaite reporter sur le support 20 de l'objet 100.

Parallèlement à la réalisation de l'ensemble 16, le support 20 peut être préparé pour recevoir le report de l'ensemble 16.

Pour cela, comme représenté sur la figure 1G, une couche d'adhésion 22 est déposée, par exemple par un dépôt de type CVD ou PVD, sur une face du support 20 destinée à recevoir l'ensemble 16. Cette couche d'adhésion 22 peut être à base d'un matériau minéral tel que du dioxyde de silicium ou du nitrure de silicium, et/ou de nature similaire à celle de la couche d'adhésion 18. Le matériau de la couche d'adhésion 22 est notamment choisi pour pouvoir réaliser par la suite un collage par adhésion moléculaire avec l'ensemble 16 et plus particulièrement avec la couche d'adhésion 18. Il est également possible de recouvrir les autres faces du support 20 par le matériau de la couche d'adhésion 22 afin de réaliser une protection mécanique du support 20 au cours des étapes ultérieures du procédé.

On réalise ensuite un traitement de surface de la couche d'adhésion 22, par exemple un polissage mécano-chimique de la surface 22' de la couche d'adhésion 22, permettant d'éliminer l'éventuelle rugosité du support 20 qui peut se retrouver au niveau de la face 22' de la couche d'adhésion 22 et obtenir ainsi une surface plane (figure 1H).

Enfin, comme représenté sur la figure 1I, l'ensemble 16, ou une partie de l'ensemble 16 comportant l'élément graphique, est reporté sur le support 20 en réalisant un collage par adhésion moléculaire, sans apport de matière. Dans le mode de réalisation décrit ici, le collage par adhésion moléculaire est réalisé entre la couche d'adhésion 22 et la couche d'adhésion 18 qui sont ici à base du même matériau. Le collage par adhésion moléculaire entre les deux faces planes des couches d'adhésion 18 et 22. Lorsque le support 20 est à base d'un matériau pouvant réaliser un collage par adhésion moléculaire avec la couche d'adhésion 18, la couche d'adhésion 22 peut être omise. De même, il est également possible de réaliser le collage par adhésion moléculaire directement entre le support 20 et la face du substrat 2 comportant les portions restantes 14', 14" et éventuellement les portions 12' et 12" si la nature de ces matériaux et les rugosités des faces le permettent. Les rugosités des surfaces collées par adhésion moléculaire peuvent notamment être inférieures à environ 1 nm ou 0,5 nm.

On peut ensuite réaliser une étape de traitement thermique de l'objet (support + ensemble reporté) permettant de consolider l'adhésion moléculaire réalisée. Ce traitement thermique peut notamment être un recuit réalisé à une température comprise entre environ 250°C et 1200°C. De manière avantageuse, ce recuit peut être réalisé à une température supérieure à environ 850°C afin d'obtenir la meilleure robustesse possible au niveau de l'interface du collage moléculaire (au moins équivalente à celle d'un matériau massif).

On obtient ainsi l'objet 100 comportant l'élément graphique formé par les portions 12', 12", 14', 14" visibles à travers le substrat 2 et enfoui dans la structure monolithique ainsi formée.

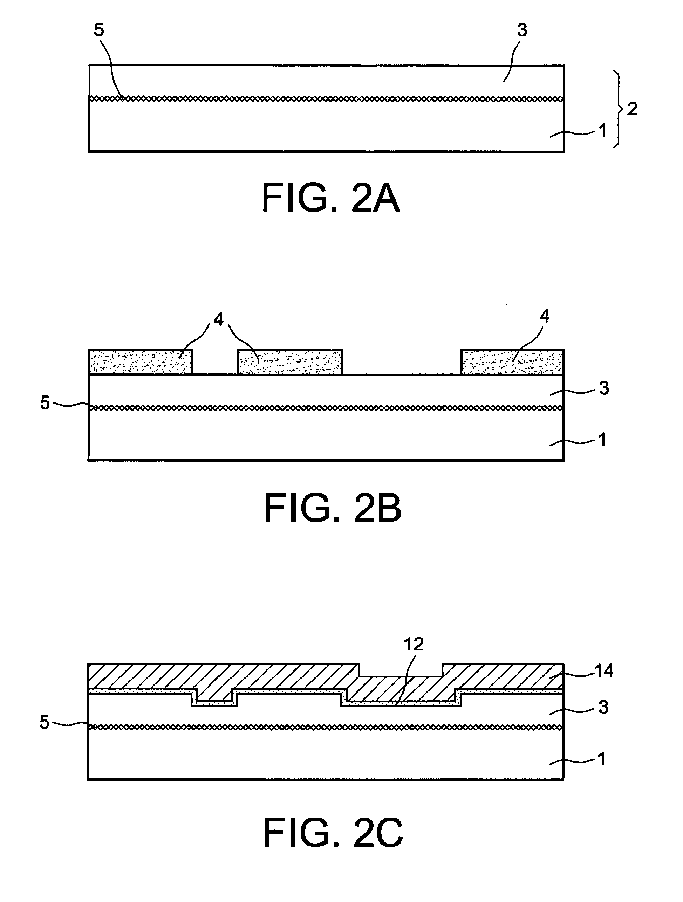

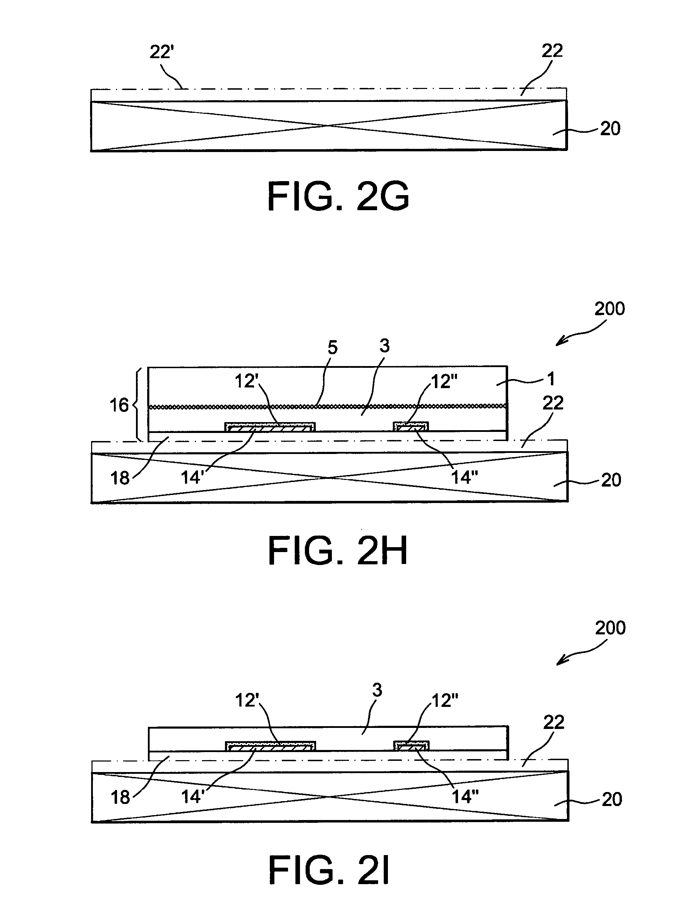

Un procédé de réalisation d'un objet 200 comportant un élément graphique réalisé sur un support 20, par exemple un objet massif tel qu'un bijou, une montre, un équipement électronique, ou encore un support de conservation d'informations, va être décrit en liaison avec les figures 2A à 2I. Dans ce second mode de réalisation, l'objet 200 est un bijou dont l'élément graphique est réalisé sur une couche mince de même nature que le support 20 qui est ici une pierre précieuse, par exemple un diamant.

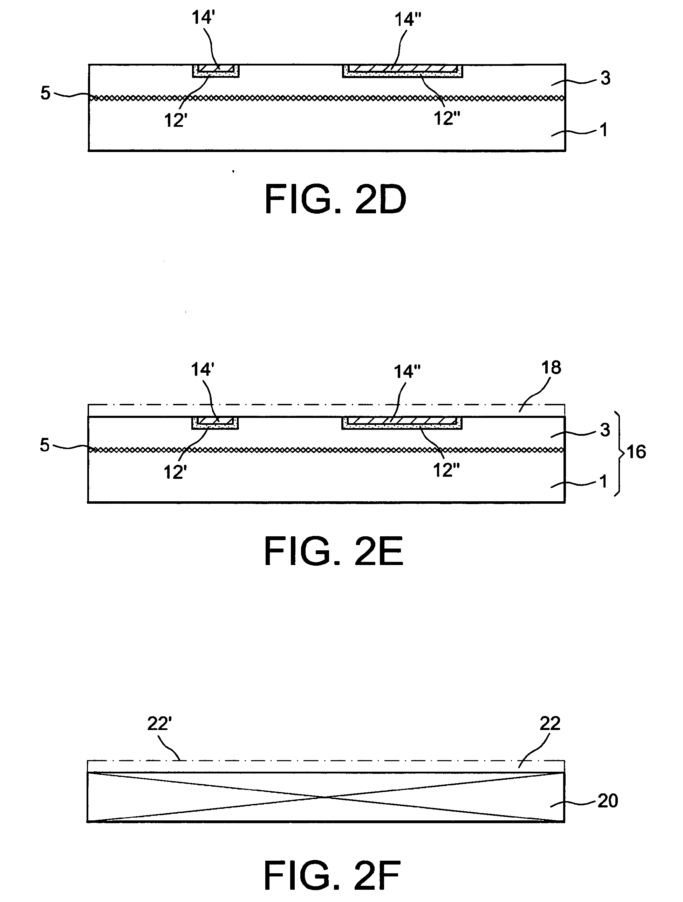

Comme représenté sur la figure 2A, on réalise un substrat 2 comportant une couche mince 3, par exemple transparente ou au moins partiellement transparente, formée sur un substrat massif 1. Cette couche mince 3 a par exemple une épaisseur inférieure à environ 1 µm et est à base d'un matériau amorphe ou cristallin, par exemple de type diamant, saphir ou plus généralement de type pierre précieuse ou semi-précieuse. La couche mince 3 est obtenue par exemple par un dépôt de type CVD ou PVD sur le substrat massif 1. Le substrat massif 1 peut par exemple être à base de silicium ou de tout autre matériau, par exemple cristallin, pouvant recevoir la couche mince 3. On réalise ensuite une interface de fracture 5, par exemple par implantation ionique, au niveau de l'interface entre la couche mince 3 et du substrat massif 1. L'épaisseur du support 20 (représenté sur les figures 2F à 2I) peut notamment être supérieure ou égale à environ 100 µm.

Dans une variante, le substrat 2 peut être obtenu en réalisant un traitement spécifique par implantation ionique dans un matériau par exemple cristallin, formant une zone de fracture 5 qui délimite une première partie du matériau formant la couche mince 3 et une seconde partie du matériau formant le substrat massif 1.

Sur la figure 2B, comme dans le premier mode de réalisation décrit précédemment, on réalise ensuite, sur une face de la couche mince 3, un masque 4, dont le motif correspond à celui de l'élément graphique à réaliser, à partir d'une couche de résine photosensible déposée sur la couche mince 3 et une ou plusieurs étapes de lithographie et de gravure.

La face de la couche mince 3 sur laquelle est réalisé le masque 4 est ensuite gravée par voie chimique isotrope ou anisotrope ou sèche (mode plasma, gravure ionique réactive ou usinage ionique) formant des creux dont le motif est conforme à celui de l'élément graphique. Le masque de gravure 4 est ensuite éliminé. Le motif de l'élément graphique se trouve donc reporté dans la couche mince 3.

Dans une variante de réalisation, il est également possible que le masque 4 soit formé dans une couche de type minéral ou à base de métal, comme décrit précédemment en liaison avec une variante du premier mode de réalisation. Dans une autre variante, il est également possible de ne pas utiliser de masque de gravure et de réaliser le motif de l'élément graphique par ablation laser.

On réalise ensuite le dépôt d'une couche d'adhérence 12 et d'une couche 14, comme pour le premier mode de réalisation décrit ci-dessus (voir figure 2C).

Comme représenté sur la figure 2D, on réalise ensuite un polissage mécano-chimique de la couche 14 et de la couche d'adhérence 12, avec arrêt sur la face de la couche mince 3 sur laquelle ont été déposées les couches 12 et 14. On conserve ainsi des portions 12', 12 " de la couche d'adhérence 12 et des portions 14', 14" de la couche 14 disposées dans les creux précédemment réalisés dans la couche mince 3. Ces portions restantes 12', 12" et 14', 14" forment donc le motif de l'élément graphique que l'on souhaite réaliser. Cette face de la couche mince 3 peut ensuite être traitée.

Comme dans une variante décrite en liaison avec le premier mode de réalisation, la couche 14 peut être déposée sur la couche mince 3 et dans les creux 6 formés dans la couche mince 3 sans déposer au préalable de couche d'adhérence 12 sur la couche mince 3. L'épaisseur de la couche 14 déposée peut dans ce cas être supérieure à la profondeur des creux 6. Comme décrit précédemment, on réalise alors un polissage mécano-chimique de la couche 14 déposée afin de ne conserver que les portions 14', 14" déposées dans les creux 6.

Une couche d'adhésion 18, par exemple similaire à celle décrite précédemment en liaison avec le premier mode de réalisation, est ensuite déposée, par exemple par CVD ou PVD, sur la face de la couche mince 3 comportant les portions 12', 12", 14', 14" déposées dans les creux (figure 2E).

Comme pour le premier mode de réalisation, il est possible, préalablement au dépôt de la couche d'adhésion 18, de former en surface des portions 14' et 14" des zones à base de métal et de semi-conducteur, par exemple à base de siliciure, lorsque les portions 14' et 14" sont à base de métal, afin d'améliorer l'adhérence de la couche d'adhésion 18 sur ces portions 14', 14".

Il est également possible de réaliser tout d'abord un dépôt d'une couche anti-réflective et/ou d'autres couches sur la face de la couche mince 3 comportant les portions restantes 14', 14", puis de déposer la couche d'adhésion 18 sur cette couche anti-réflective et/ou sur les autres couches.

On obtient ainsi un ensemble 16, formé ici par le substrat 2, c'est-à-dire le substrat massif 1 et la couche mince 3, les portions restantes 14', 14" de la couche 14, les portions restantes 12', 12" de la couche d'adhérence 12 et la couche d'adhésion 18, comportant le motif de l'élément graphique que l'on souhaite reporter sur le support 20 de l'objet 200.

Parallèlement à la réalisation de l'ensemble 16, le support 20 peut être préparé pour recevoir le report de l'ensemble 16.

Pour cela, comme représenté sur la figure 2F, une couche d'adhésion 22, par exemple similaire à celle décrite en liaison avec le premier mode de réalisation, est déposée, par exemple par un dépôt de type CVD ou PVD, sur une face du support 20 destinée à recevoir l'ensemble 16. Il est également possible de recouvrir les autres faces du support 20 par le matériau de la couche d'adhésion 22 afin de réaliser une protection mécanique du support 20 au cours des étapes ultérieures du procédé.

On réalise ensuite un traitement de surface de la couche d'adhésion 22, par exemple un polissage mécano-chimique de la surface 22' de la couche d'adhésion 22, permettant d'éliminer l'éventuelle rugosité du support 20 qui peut se retrouver au niveau de la face 22' de la couche d'adhésion 22 (figure 2G).

Comme représenté sur la figure 2H, l'ensemble 16, ou une partie de l'ensemble 16 comportant l'élément graphique, est reporté sur le support 20 en réalisant un collage par adhésion moléculaire, sans apport de matière. Dans le second mode de réalisation décrit ici, le collage par adhésion moléculaire est réalisé entre la couche d'adhésion 22 et la couche d'adhésion 18 qui sont ici à base du même matériau. Lorsque le support 20 est à base d'un matériau pouvant réaliser un collage par adhésion moléculaire avec la couche d'adhésion 18, la couche d'adhésion 22 peut être omise. De même, il est également possible de réalisé le collage par adhésion moléculaire directement entre le support 20 et la face de la couche mince 3 comportant les portions restantes 14', 14" et éventuellement les portions 12' et 12" si la nature de ces matériaux et les rugosités des faces le permettent. Les rugosités des surfaces collées par adhésion moléculaire peuvent notamment être inférieures à environ 1 nm ou 0,5 nm.

On peut ensuite réaliser une étape de traitement thermique de l'objet (support + ensemble reporté) permettant de consolider l'adhésion moléculaire réalisée et réaliser la fracture entre le substrat massif 1 et la couche mince 3 suivant l'interface de fracture 5. Ce traitement thermique peut notamment être un recuit réalisé à une température comprise entre environ 250°C et 1200°C.

On obtient ainsi l'objet 200 comportant l'élément graphique formé par les portions 12', 12", 14', 14" visibles à travers la couche mince 3 et enfoui dans la structure monolithique ainsi formée.

Il est enfin possible de réaliser un polissage mécano-chimique de la couche mince 3 pouvant permettre d'améliorer les qualités optiques, c'est-à-dire la visibilité de l'élément graphique.

## Revendications

1. Objet (100, 200) muni d'au moins un élément graphique, comportant au moins un substrat (2) au moins partiellement transparent dont au moins une face comprend des creux (6) formant un motif de l'élément graphique remplis par au moins un matériau (14, 14', 14"), ladite face du substrat (2) étant solidarisée à au moins une face d'au moins un support (20) par adhésion moléculaire, le substrat (2) et le support (20) formant une structure monolithique.

2. Objet (100, 200) selon la revendication 1, le matériau (14, 14', 14") disposé dans les creux (6) étant à base d'au moins un matériau minéral, et/ou le substrat (2) étant à base d'au moins un matériau amorphe ou cristallin.

3. Objet (100, 200) selon l'une des revendications précédentes, comportant en outre un matériau d'adhérence (12, 12', 12") disposé dans les creux (6), entre le matériau (14, 14', 14") également disposé dans les creux (6) et le substrat (2).

4. Objet (100, 200) selon la revendication 3, le matériau d'adhérence (12, 12', 12") étant à base d'au moins un métal et/ou d'un nitrure métallique et/ou d'un oxyde métallique.

5. Objet (100, 200) selon l'une des revendications précédentes, comportant en outre au moins une première couche d'adhésion (18) et/ou au moins une seconde couche d'adhésion (22) disposées entre la face du substrat (2) comportant les creux (6) et le support (20), l'adhésion moléculaire étant formée entre la première couche d'adhésion (18) et le support (20), ou entre la seconde couche d'adhésion (22) et la face du substrat (2) comportant les creux (6), ou entre la première couche d'adhésion (18) et la seconde couche d'adhésion (22).

6. Objet (100, 200) selon la revendication 5, la première couche d'adhésion (18) et/ou la seconde couche d'adhésion (22) étant à base d'au moins un matériau minéral.

7. Objet (100, 200) selon l'une des revendications 5 ou 6, dans lequel, lorsque le matériau (14, 14', 14") disposé dans les creux (6) est à base de métal, ledit matériau (14, 14', 14") comporte une zone à base dudit métal et d'un semi-conducteur au niveau d'une face du matériau (14, 14', 14") opposée à une autre face du matériau (14, 14', 14") se trouvant du côté des creux (6).

8. Objet (100, 200) selon la revendication 7, dans lequel ladite zone est à base de siliciure.

9. Objet (200) selon l'une des revendications précédentes, le substrat (2) comportant une couche mince (3) au moins partiellement transparente dont une face est ladite face du substrat (2) comportant les creux et solidarisée par adhésion moléculaire au support (20).

10. Objet (100, 200) selon l'une des revendications précédentes, ledit objet (100, 200) étant un bijou, une pierre, une montre, un dispositif électronique ou un support de données.

11. Procédé de réalisation d'un objet (100, 200) muni d'au moins un élément graphique, comportant au moins les étapes de :
a) gravure d'au moins une face d'un substrat (2) au moins partiellement transparent selon un motif de l'élément graphique, formant des creux (6) dans ladite face,
b) dépôt d'au moins un matériau (14, 14', 14") au moins dans les creux (6) formés dans la face du substrat (2),
c) solidarisation de la face du substrat (2) comportant les creux (6) à au moins une face d'au moins un support (20) par adhésion moléculaire, le substrat (2) et le support (20) formant une structure monolithique.

12. Procédé selon la revendication 11, l'étape b) de dépôt étant obtenue par la mise en oeuvre d'une étape de dépôt d'une couche (14) à base du matériau sur la face du substrat (2) comportant les creux (6) et dans les creux (6), et d'une étape de polissage mécano-chimique de ladite couche (14) à base du matériau avec arrêt sur la face du substrat (2), ne laissant subsister de ladite couche (14) que des portions (14', 14") de matériau disposées dans les creux (6).

13. Procédé selon la revendication 11, l'étape b) de dépôt étant obtenue par la mise en oeuvre d'une étape de remplissage des creux (6) par sérigraphie, le matériau (14', 14") disposé dans les creux (6) comportant une encre ou pâte chargée en métal, et d'une étape de séchage du matériau (14', 14").

14. Procédé selon la revendication 13, comportant en outre, après l'étape de séchage du matériau (14', 14") disposé dans les creux (6), une étape de polissage mécano-chimique de la face du substrat (2).

15. Procédé selon la revendication 11, comportant en outre, entre l'étape a) de gravure et l'étape b) de dépôt du matériau (14, 14', 14'') dans les creux (6), une étape de dépôt d'un matériau d'adhérence (12, 12', 12") dans les creux (6) tel que le matériau d'adhérence (12, 12', 12") remplisse partiellement les creux (6), l'autre matériau (14, 14', 14") étant ensuite déposé, au cours de l'étape b), sur le matériau d'adhérence (12, 12', 12").

16. Procédé selon la revendication 15, l'étape de dépôt du matériau d'adhérence (12, 12', 12") étant obtenue par la mise en oeuvre d'une étape de dépôt d'une couche (12) à base du matériau d'adhérence sur la face du substrat (2) comportant les creux (6) et dans les creux (6), l'étape b) de dépôt étant obtenue par la mise en oeuvre d'une étape de dépôt d'une couche (14) à base de l'autre matériau sur la couche (12) à base du matériau d'adhérence et d'une étape de polissage mécano-chimique desdites couches (12, 14) à base du matériau d'adhérence et de l'autre matériau avec arrêt sur la face du substrat (2), ne laissant subsister desdites couches (12, 14) que des portions (12', 12", 14', 14") de matériaux disposées dans les creux (6).

17. Procédé selon l'une des revendications 11 à 16, comportant en outre, entre l'étape b) de dépôt et l'étape c) de solidarisation, une étape de dépôt d'une couche d'adhésion (18) sur la face du substrat (2) comportant les creux (6), recouvrant également le ou les matériaux (12', 12", 14', 14") disposés dans les creux (6), l'étape c) de solidarisation étant obtenue par la mise en oeuvre d'un collage par adhésion moléculaire entre ladite couche d'adhésion (18) et le support (20).

18. Procédé selon la revendication 17, comportant en outre, entre l'étape de dépôt de la couche d'adhésion (18) sur la face du substrat (2) comportant les creux (6) et l'étape c) de solidarisation, une étape de polissage mécano-chimique de la couche d'adhésion (18) déposée sur la face du substrat (2) comportant les creux (6).

19. Procédé selon l'une des revendications 11 à 16, comportant en outre, avant l'étape c) de solidarisation, une étape de dépôt d'une couche d'adhésion (22) sur la face du support (20), l'étape c) de solidarisation étant obtenue par la mise en oeuvre d'un collage par adhésion moléculaire entre ladite couche d'adhésion (22) et la face du substrat (2) comportant les creux (6).

20. Procédé selon l'une des revendications 11 à 16, comportant en outre :
- entre l'étape b) de dépôt et l'étape c) de solidarisation, une étape de dépôt d'une première couche d'adhésion (18) sur la face du substrat (2) comportant les creux (6), recouvrant également le ou les matériaux (12', 12", 14', 14") disposés dans les creux (6),
- avant l'étape c) de solidarisation, une étape de dépôt d'une seconde couche d'adhésion (22) sur la face du support (20),
l'étape c) de solidarisation étant obtenue par la mise en oeuvre d'un collage par adhésion moléculaire entre les deux couches d'adhésion (18, 22).

21. Procédé selon l'une des revendications 17, 18 ou 20, comportant en outre, lorsque le matériau (14, 14', 14") déposé à l'étape b) est à base de métal, entre l'étape b) de dépôt et l'étape de dépôt de la couche d'adhésion (18), une étape de formation d'une zone à base dudit métal et d'un semi-conducteur au niveau d'une face du matériau (14, 14', 14") opposée à une autre face du matériau (14, 14', 14") se trouvant du côté des creux (6).

22. Procédé selon la revendication 21, dans lequel l'étape de formation de ladite zone est obtenue par la mise en oeuvre d'une étape de siliciuration du matériau (14, 14', 14") déposé dans les creux (6).

23. Procédé selon l'une des revendications 19 à 22, comportant en outre, entre l'étape de dépôt de la couche d'adhésion (22) sur la face du support (20) et l'étape c) de solidarisation, une étape de polissage mécano-chimique de la couche d'adhésion (22) déposée sur le support (20).

24. Procédé selon l'une des revendications 11 à 23, l'étape a) de gravure de la face du substrat (2) étant obtenue par la mise en oeuvre d'étapes de masquage, de lithographie et de gravure dans la face du substrat (2), ou d'au moins une étape d'ablation laser directement dans la face du substrat (2).

25. Procédé selon l'une des revendications 11 à 24, comportant en outre, avant l'étape a) de gravure, une étape de réalisation d'une couche mince (3) au moins partiellement transparente sur un substrat massif (1), formant le substrat (2) au moins partiellement transparent, et une étape de réalisation d'une interface de fracture (5) entre la couche mince (3) et le substrat massif (1), les creux formés à l'étape a) de gravure étant réalisés dans une face de la couche mince (3), et comportant en outre, après l'étape c) de solidarisation, une étape de fracture entre la couche mince (3) et le substrat massif (1), au niveau de l'interface de fracture (5), la structure monolithique étant formée par la couche mince (3) et le support (20).

26. Procédé selon la revendication 25, la couche mince (3) étant réalisée par un dépôt CVD ou PVD sur le substrat massif (1), et/ou l'interface de fracture (5) étant réalisée par implantation ionique.

27. Procédé selon l'une des revendications 11 à 24, comportant en outre, avant l'étape a) de gravure, une étape de réalisation d'une interface de fracture (5) dans le substrat (2), une première partie du substrat (2) formant une couche mince (3) au moins partiellement transparente et une seconde partie du substrat (2) formant un substrat massif (1), l'interface de fracture (5) étant disposée entre les deux parties du substrat (2), les creux formés à l'étape a) de gravure étant réalisés dans une face de la couche mince (3), et comportant en outre, après l'étape c) de solidarisation, une étape de fracture entre la couche mince (3) et le substrat massif (1), au niveau de l'interface de fracture (5), la structure monolithique étant formée par la couche mince (3) et le support (20).

28. Procédé selon l'une des revendications 11 à 27, comportant en outre, après l'étape c) de solidarisation, une étape de traitement thermique de l'objet (100, 200) consolidant l'adhésion moléculaire.

## Patentansprüche

1. Mit mindestens einem graphischen Element versehenes Objekt (100, 200), welches zumindest ein zumindest teilweise transparentes Substrat (2) aufweist, von dem zumindest eine Seite bzw. Fläche Vertiefungen (6) umfasst, welche ein Muster des graphischen Elements bilden und mit zumindest einem Werkstoff (14, 14', 14") gefüllt sind, wobei die besagte Seite bzw. Fläche des Substrats (2) mit mindestens einer Seite bzw. Fläche zumindest eines Trägers (20) durch molekulare Haftung verbunden ist, wobei das Substrat (2) und der Träger (20) eine monolithische Struktur bilden.

2. Objekt (100, 200) nach Anspruch 1, wobei der in den Vertiefungen (6) angeordnete Werkstoff (14, 14' 14") auf zumindest einem mineralischen Werkstoff basiert, und/oder das Substrat (2) auf zumindest einem amorphen oder kristallinen Werkstoff basiert.

3. Objekt (100, 200) nach einem der vorhergehenden Ansprüche, welches darüber hinaus einen Haftwerkstoff (12, 12', 12") aufweist, welcher in den Vertiefungen (6) zwischen dem ebenfalls in den Vertiefungen (6) angeordneten Werkstoff (14, 14' 14") und dem Substrat (2) angeordnet ist.

4. Objekt (100, 200) nach Anspruch 3, wobei der Haftwerkstoff (12, 12', 12") zumindest auf einem Metall und/oder einem Metallnitrid und/oder einem Metalloxid basiert.

5. Objekt (100, 200) nach einem der vorhergehenden Ansprüche, welches darüber hinaus zumindest eine erste Haftschicht (18) und/oder zumindest eine zweite Haftschicht (22) aufweist, welche zwischen der die Vertiefungen (6) aufweisenden Seite bzw. Fläche des Substrats (2) und dem Träger (20) angeordnet sind, wobei die molekulare Haftung zwischen der ersten Haftschicht (18) und dem Träger (20) gebildet wird, oder zwischen der zweiten Haftschicht (22) und der die Vertiefungen (6) aufweisenden Seite bzw. Fläche des Substrats (2), oder zwischen der ersten Haftschicht (18) und der zweiten Haftschicht (22).

6. Objekt (100, 200) nach Anspruch 5, wobei die erste Haftschicht (18) und/oder die zweite Haftschicht (22) auf zumindest einem mineralischen Werkstoff basieren.

7. Objekt (100, 200) nach einem der Ansprüche 5 oder 6, in welchem, wenn der in den Vertiefungen (6) angeordnete Werkstoff (14, 14', 14") auf Metall basiert, der besagte Werkstoff (14, 14', 14") einen Bereich auf Basis dieses Metalls und eines Halbleiters bezogen auf eine Seite bzw. Fläche des Werkstoffs (14, 14', 14"), welche einer sich auf der Seite der Vertiefungen (6) befindlichen anderen Seite bzw. Fläche des Werkstoffs (14, 14', 14") gegen- überliegt, aufweist.

8. Objekt (100, 200) nach Anspruch 7, in welchem der besagte Bereich auf Silizid basiert.

9. Objekt (200) nach einem der vorhergehenden Ansprüche, wobei das Substrat (2) eine zumindest teilweise transparente dünne Schicht (3) aufweist, deren eine Seite die die Vertiefungen aufweisende Seite bzw. Fläche des Substrats (2) ist, und welche durch molekulare Haftung mit dem Träger (20) verbunden ist.

10. Objekt (100, 200) nach einem der vorhergehenden Ansprüche, wobei das besagte Objekt (100, 200) ein Juwel, ein Stein, eine Uhr, eine elektronische Vorrichtung oder ein Datenträger ist.

11. Verfahren zur Herstellung eines Objekts (100, 200), welches mindestens ein graphisches Element aufweist, wobei das Verfahren zumindest die folgenden Schritte umfasst:
a) Ätzen zumindest einer Seite oder Fläche eines Substrats (2), welches zumindest teilweise gemäß einem Muster des graphischen Elements transparent ist, wobei Vertiefungen (6) in der Seite bzw. Fläche gebildet werden;
b) Aufbringen mindestens eines Werkstoffs (14, 14', 14") zumindest in die Vertiefungen (6), welche in der Seite bzw. Fläche des Substrats (2) gebildet sind;
c) Verbinden der Seite bzw. Fläche des Substrats (2), welches die Vertiefungen (6) umfasst, mit mindestens einer Seite bzw. Fläche zumindest eines Trägers (20) durch molekulare Haftung, wobei das Substrat (2) und der Träger (20) eine monolithische Struktur bilden.

12. Verfahren nach Anspruch 11, wobei der Schritt b) des Aufbringens durch die Durchführung eines Schrittes der Aufbringung einer Schicht (14) auf Basis des Werkstoffs auf die die Vertiefungen (6) aufweisende Seite bzw. Fläche des Substrats (2) und in die Vertiefungen erreicht wird, und durch die Durchführung eines Schritts des chemisch-mechanischen Polierens der besagten Schicht (14) auf Basis des Werkstoffs mit Unterbrechung auf der Seite bzw. Fläche des Substrats (2), wobei von der besagten Schicht (14) nur die Werkstoffabschnitte (14', 14"), welche in den Vertiefungen angeordnet sind, bestehen bleiben.

13. Verfahren nach Anspruch 11, wobei der Schritt b) des Aufbringens durch die Durchführung eines Schrittes des Füllens der Vertiefungen (6) durch Siebdruck erreicht wird, wobei der in den Vertiefungen (6) angeordnete Werkstoff (14', 14") eine Tinte oder eine metallangereicherte Paste umfasst, und durch die Durchführung eines Schrittes der Trocknung des Werkstoffs (14', 14").

14. Verfahren nach Anspruch 13, welches darüber hinaus nach dem Schritt der Trocknung des Werkstoffs (14', 14"), welcher in den Vertiefungen (6) angeordnet ist, einen Schritt des chemisch-mechanischen Polierens der Seite bzw. Fläche des Substrats (2) umfasst.

15. Verfahren nach Anspruch 11, welches darüber hinaus zwischen dem Schritt a) des Ätzens und dem Schritt b) des Auftragens des Werkstoffs (14, 14', 14") in den Vertiefungen (6) einen Schritt des Auftragens eines Haftwerkstoffs (12, 12', 12") in den Vertiefungen derart umfasst, so dass der Haftwerkstoff (12, 12', 12") teilweise die Vertiefungen (6) füllt, wobei der andere Werkstoff (14, 14', 14") anschließend während dem Schritt b) auf den Haftwerkstoff (12, 12', 12") aufgebracht wird.

16. Verfahren nach Anspruch 15, wobei der Schritt des Auftragens des Haftwerkstofffs (12, 12', 12") durch die Durchführung eines Schrittes des Aufbringens einer Schicht (12) auf Basis des Haftwerkstoffs auf die die Vertiefungen aufweisende Seite bzw. Fläche des Substrats (2) und in die Vertiefungen (6) erreicht wird, wobei der Schritt b) des Auftragens durch die Durchführung eines Schrittes des Auftragens einer Schicht (14) auf Basis des anderen Werkstoffs auf die Schicht (12) auf Basis des Haftwerkstoffs und durch die Durchführung eines Schrittes des chemisch-mechanischen Polierens der besagten Schichten (12, 14) auf Basis des Haftwerkstoffs und auf Basis des anderen Werkstoffs mit Unterbrechung auf der Seite bzw. Fläche des Substrats (2) erreicht wird, wobei von den besagten Schichten (12, 14) nur die Werkstoffabschnitte (12', 12", 14', 14") bestehen bleiben, welche in den Vertiefungen (6) angeordnet sind.

17. Verfahren nach einem der Ansprüche 11 bis 16, welches darüber hinaus zwischen dem Schritt b) des Aufbringens und dem Schritt c) des Verbindens einen Schritt des Aufbringens einer Haftschicht (18) auf die die Vertiefungen aufweisende Seite bzw. Fläche des Substrats (2) umfasst, wobei der Werkstoff oder die Werkstoffe (12', 12", 14', 14"), welche in den Vertiefungen (6) angeordnet sind, ebenfalls bedeckt sind, wobei der Schritt c) des Verbindens durch die Durchführung einer Anklebung durch molekulare Haftung zwischen der besagten Haftschicht (18) und dem Träger (20) erreicht wird.

18. Verfahren nach Anspruch 17, welches darüber hinaus zwischen dem Schritt des Aufbringens der Haftschicht (18) auf die die Vertiefungen (6) aufweisende Seite bzw. Fläche des Substrats (2) und der Schritt c) des Verbindens einen Schritt des chemisch-mechanischen Polierens der Haftschicht (18), welche auf der die Vertiefungen (6) aufweisenden Seite bzw. Fläche des Substrats (2) angeordnet ist, umfasst.

19. Verfahren nach einem der Ansprüche 11 bis 16, welches darüber hinaus vor dem Schritt c) des Verbindens einen Schritt des Aufbringens einer Haftschichtt (22) auf die Seite bzw. Fläche des Trägers (20) umfasst, wobei der Schritt c) des Verbindens durch die Durchführung einer Anklebung durch molekulare Haftung zwischen der Haftschicht (22) und der die Vertiefungen (6) aufweisenden Seite bzw. Fläche des Substrats (2) erreicht wird.

20. Verfahren nach einem der Ansprüche 11 bis 16, welches darüber hinaus die folgenden Schritte umfasst:
- zwischen dem Schritt b) des Aufbringens und dem Schritt c) des Verbindens einen Schritt des Auftragens einer ersten Haftschicht (18) auf die die Vertiefungen (6) aufweisende Seite bzw. Fläche des Substrats (2), wobei auch der Werkstoff oder die Werkstoffe (12', 12", 14', 14"), welche in den Vertiefungen (6) angeordnet sind, bedeckt werden;
- vor dem Schritt c) des Verbindens einen Schritt des Auftragens einer zweiten Haftschicht (22) auf die Seite bzw. Fläche des Trägers (20);
wobei der Schritt c) des Verbindens durch die Durchführung einer Anklebung durch molekulare Haftung zwischen den beiden Haftschichten (18, 22) erreicht wird.

21. Verfahren nach einem der Ansprüche 17, 18 oder 20, welches darüber hinaus, wenn der bei Schritt b) aufgetragene Werkstoff (14, 14', 14") auf Metall basiert, zwischen dem Schritt b) des Aufbringens und dem Schritt des Aufbringens der Haftschicht (18) einen Schritt der Bildung eines Bereichs auf Basis des besagten Metalls und eines Halbleiters bezogen auf eine Seite oder Fläche des Werkstoffs (14, 14', 14") aufweist, welcher einer anderen Seite bzw. Fläche des Werkstoffs (14, 14', 14"), die sich an der Seite der Vertiefungen (6) befindet, gegenüberliegt.

22. Verfahren nach Anspruch 21, in welchem der Schritt der Bildung des besagten Bereichs durch die Durchführung eines Schrittes der Silizierung des Werkstoffs (14, 14', 14"), welcher in den Vertiefungen (6) angeordnet ist, erreicht wird.

23. Verfahren nach einem der Ansprüche 19 bis 22, welches darüber hinaus zwischen dem Schritt des Aufbringens der Haftschicht (22) auf die Seite bzw. Fläche des Trägers (20) und dem Schritt c) des Verbindens einen Schritt des chemisch-mechanischen Polierens der Haftschicht (22), welche auf dem Träger (20) angeordnet ist, aufweist.

24. Verfahren nach einem der Ansprüche 11 bis 23, wobei der Schritt a) des Ätzens der Seite bzw. Fläche des Substrats (2) durch die Durchführung der Schritte der Maskierung, der Lithographie und der Ätzung in der Seite bzw. Fläche des Substrats (2), oder zumindest eines Schrittes der Laserablation direkt in der Seite bzw. Fläche des Substrats (2) erreicht wird.

25. Verfahren nach einem der Ansprüche 11 bis 24, welches darüber hinaus vor dem Schritt a) des Ätzens einen Schritt der Herstellung einer zumindest teilweise transparenten dünnen Schicht (3) auf einem Hauptsubstrat (1) umfasst, wobei das zumindest teilweise transparente Substrat (2) gebildet wird, sowie einen Schritt der Herstellung einer Bruchschnittstelle (5) zwischen der dünnen Schicht (3) und dem Hauptsubstrat (1), wobei die in Schritt a) des Ätzens gebildeten Vertiefungen (6) in einer Seite bzw. Fläche der dünnen Schicht (3) realisiert werden, und wobei das Verfahren darüber hinaus nach dem Schritt c) des Verbindens einen Schritt des Brechens zwischen der dünnen Schicht (3) und dem Hauptsubstrat (1) bezogen auf die Bruchschnittstelle (5) umfasst, wobei die monolithische Struktur durch die dünne Schicht (3) und den Träger (20) gebildet wird.

26. Verfahren nach Anspruch 25, wobei die dünne Schicht (3) durch eine CVD- oder PVD-Abscheidung auf das Hauptsubstrat (1) realisiert wird, und/oder wobei die Bruchschnittstelle (5) durch Ionenimplantation realisiert wird.

27. Verfahren nach einem der Ansprüche 11 bis 24, welches darüber hinaus vor dem Schritt a) des Ätzens einen Schritt der Realisierung einer Bruchschnittstelle (5) in dem Substrat (2) umfasst, wobei ein erster Teil des Substrats (2) eine zumindest teilweise transparente dünne Schicht (3) und ein zweiter Teil des Substrats (2) ein Hauptsubstrat (1) bildet, wobei die Bruchschnittstelle (5) zwischen den beiden Teilen des Substrats (2) angeordnet ist, wobei die in dem Schritt a) des Ätzens gebildeten Vertiefungen in einer Seite bzw. Fläche der dünnen Schicht (3) gebildet sind, und wobei das Verfahren darüber hinaus nach dem Schritt c) des Verbindens einen Schritt des Brechens zwischen der dünnen Schicht (3) und dem Hauptsubstrat (1) bezogen auf die Bruchschnittstelle (5) umfasst, wobei die monolithische Struktur durch die dünne Schicht (3) und den Träger (20) gebildet wird.

28. Verfahren nach einem der Ansprüche 11 bis 27, welches darüber hinaus nach dem Schritt c) des Verbindens einen Schritt der Wärmebehandlung des Objekts (100, 200) umfasst, wodurch die molekulare Haftung verstärkt wird.

## Claims

1. An object (100, 200) provided with at least one graphic element, including at least one at least partly transparent substrate (2), at least one face of which comprises recesses (6) forming a pattern of the graphic element filled with at least one material (14, 14', 14"), said face of the substrate (2) being fixed to at least one face of at least one support (20) by wafer bonding, the substrate (2) and the support (20) forming a monolithic structure.

2. The object (100, 200) according to claim 1, the material (14, 14', 14") positioned in the recesses (6) being composed of at least one mineral material, and/or the substrate (2) being composed of at least one amorphous or crystalline material.

3. The object (100, 200) according to any of the preceding claims, further including an adherence material (12, 12', 12") positioned in the recesses (6), between the material (14, 14', 14") also positioned in the recesses (6) and the substrate (2).

4. The object (100, 200) according to claim 3, the adherence material (12, 12', 12") being composed of at least one metal and/or a metal nitride and/or a metal oxide.

5. The object (100, 200) according to any of the preceding claims, further including at least one first adhesion layer (18) and/or at least one second adhesion layer (22) positioned between the face of the substrate (2) including the recesses (6) and the support (20), wafer bonding being formed between the first adhesion layer (18) and the support (20), or between the second adhesion layer (22) and the face of the substrate (2) including the recesses (6), or between the first adhesion layer (18) and the second adhesion layer (22).

6. The object (100, 200) according to claim 5, the first adhesion layer (18) and/or the second adhesion layer (22) being composed of at least one mineral material.

7. The object (100, 200) according to any of claims 5 or 6, wherein, when the material (14, 14', 14") positioned in the recesses (6) is composed of metal, said material (14, 14', 14") includes an area composed of said metal and of a semiconductor at a face of the material (14, 14', 14") opposite to another face of the material (14, 14', 14") located on the side of the recesses (6).

8. The object (100, 200) according to claim 7, wherein said area is composed of silicide.

9. The object (200) according to any of the preceding claims, the substrate (2) including a thin at least partly transparent layer (3), one face of which is said face of the substrate (2) including the recesses and fixed by wafer bonding to the support (20).

10. The object (100, 200) according to any of the preceding claims, said object (100, 200) being a jewel, a stone, a watch, an electronic device or a data medium.

11. A method for making an object (100, 200) provided with at least one graphic element, including at least the steps of:
a) etching at least one face of at least one partly transparent substrate (2) according to a pattern of the graphic element, forming recesses (6) on said face,
b) depositing at least one material (14, 14', 14") at least in the recesses (6) formed in the face of the substrate (2),
c) fixing the face of the substrate (2) including the recesses (6) to at least one face of at least one support (20) by wafer bonding, the substrate (2) and the support (20) forming a monolithic structure.

12. The method according to claim 11, the deposition step b) being obtained by applying a step for depositing a layer (14) composed of the material onto the face of the substrate (2) including the recesses (6) and in the recesses (6), and a step for mechanochemical polishing of said layer (14) composed of the material with stop on the face of the substrate (2), only letting material portions (14', 14") of said layer (14) positioned in the recesses (6) subsist.

13. The method according to claim 11, the deposition step b) being obtained by applying a step for filling recesses (6) by screen-printing, the material (14', 14") positioned in the recesses (6) including an ink or paste loaded with metal, and a step for drying the material (14', 14").

14. The method according to claim 13, further including, after the step for drying the material (14', 14") positioned in the recesses (6), a step for mechanochemical polishing of the face of the substrate (2).

15. The method according to claim 11, further including, between the etching step a) and the step b) for depositing the material (14, 14', 14") in the recesses (6), a step for depositing an adherence material (12, 12', 12") in the recesses (6) so that the adherence material (12, 12', 12") partly fills the recesses (6), the other material (14, 14', 14") being then deposited, during step b), onto the adherence material (12, 12', 12").

16. The method according to claim 15, the step for depositing the adherence material (12, 12', 12") being obtained by applying a step for depositing a layer (12) composed of the adherence material onto the face of the substrate (2) including the recesses (6) and in the recesses (6), the deposition step b) being obtained by applying a step for depositing a layer (14) composed of the other material onto the layer (12) composed of the adherence material and a step for mechanochemical polishing of said layers (12, 14) composed of the adherence material and of the other material with stop on the face of the substrate (2), only letting material portions (12', 12", 14', 14") of said layers (12, 14) positioned in the recesses (6) subsist.

17. The method according to any of claims 11 to 16, further including, between the deposition step b) and the fixing step c), a step for depositing an adhesion layer (18) onto the face of the substrate (2) including the recesses (6), also covering the material (s) (12, 12", 14', 14") positioned in the recesses (6), the fixing step c) being obtained by applying bonding by wafer bonding between said adhesion layer (18) and the support (20).

18. The method according to claim 17, further including, between the step for depositing the adhesion layer (18) onto the face of the substrate (2) including the recesses (6) and the fixing step c), a step for mechanochemical polishing of the adhesion layer (18) deposited onto the face of the substrate (2) including the recesses (6).

19. The method according to any of claims 11 to 16, further including, before the fixing step c), a step for depositing an adhesion layer (22) onto the face of the support (20), the fixing step c) being obtained by applying bonding by wafer bonding between said adhesion layer (22) and the face of the substrate (2) including the recesses (6).

20. The method according to any of claims 11 to 16, further including:
- between the deposition step b) and the fixing step c), a step for depositing a first adhesion layer (18) onto the face of the substrate (2) including the recesses (6), also covering the material(s) (12', 12", 14', 14") positioned in the recesses (6),
- before the fixing step c), a step for depositing a second adhesion layer (22) onto the face of the support (20),
the fixing step c) being obtained by applying bonding by wafer bonding between both adhesion layers (18, 22).

21. The method according to any of claims 17, 18 or 20, further including, when the material (14, 14', 14") deposited in step b) is composed of metal, between the deposition step b) and the step for depositing the adhesion layer (18), a step for forming an area composed of said metal and of a semiconductor at a face of the material (14, 14', 14") opposite to another face of the material (14, 14', 14") located on the side of the recesses (6).

22. The method according to claim 21, wherein the step for forming said area is obtained by applying a step for siliconizing the material (14, 14', 14") deposited in the recesses (6).

23. The method according to any of claims 19 to 22, further including, between the step for depositing the adhesion layer (22) onto the face of the support (20) and the fixing step c), a step for mechanochemical polishing of the adhesion layer (22) deposited on the support (20).

24. The method according to any of claims 11 to 23, the step a) for etching the face of the substrate (2) being obtained by applying masking, lithographic and etching steps in the face of the substrate (2), or at least one laser ablation step directly in the face of the substrate (2).

25. The method according to any of claims 11 to 24, further including, before the etching step a), a step for making a thin at least partly transparent layer (3) on a massive substrate (1), forming the at least partly transparent substrate (2), and a step for making a fracture interface (5) between the thin layer (3) and the massive substrate (1), the recesses formed in the etching step a) being made in a face of the thin layer (3), and further including, after the fixing step c), a fracture step between the thin layer (3) and the massive substrate (1), at the fracture interface (5), the monolithic structure being formed by the thin layer (3) and the support (20).

26. The method according to claim 25, the thin layer (3) being made by CVD or PVD deposition on the massive substrate (1), and/or the fracture interface (5) being achieved by ion implantation.

27. The method according to claim 11 to 24, further including, before the etching step a), a step for making a fracture interface (5) in the substrate (2), a first portion of the substrate (2) forming a thin at least partly transparent layer (3) and a second portion of the substrate (2) forming a massive substrate (1), the fracture interface (5) being positioned between both portions of the substrate (2), the recesses formed in the etching step a) being made in a face of the thin layer (3), and further including, after the fixing step c), a fracture step between the thin layer (3) and the massive substrate (1), at the fracture interface (5), the monolithic structure being formed by the thin layer (3) and the support (20).

28. The method according to any of claims 11 to 27, further including, after the fixing step c), a step for heat treatment of the object (100, 200) consolidating wafer bonding.
